(19) Europäisches Patentamt
European Patent Office
Office européen des brevets

(11) **EP 4 312 039 A1**

(12) **EUROPEAN PATENT APPLICATION**

(43) Date of publication:
**31.01.2024 Bulletin 2024/05**

(21) Application number: **22186904.3**

(22) Date of filing: **26.07.2022**

(51) International Patent Classification (IPC):
**G01R 33/07** (2006.01)  **G01R 33/12** (2006.01)
**G01N 27/74** (2006.01)

(52) Cooperative Patent Classification (CPC):
**G01R 33/072; G01N 27/745; G01R 33/1269**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
• **Hitachi, Ltd.**
**Tokyo 100-8280 (JP)**
• **Cambridge Enterprise Limited**
**Cambridge CB2 1TN (GB)**

(72) Inventors:
• **ROY, Pierre Emanuel**
**Cambridge, CB3 0HE (GB)**

• **COWBURN, Russell**
**Cambridge, CB3 0HE (GB)**
• **PETIT, Dorothée**
**Cambridge, CB3 0HE (GB)**
• **HERBERT, Holly**
**Cambridge, CB3 0HE (GB)**

(74) Representative: **Piotrowicz, Pawel Jan Andrzej et al**
**Venner Shipley LLP**
**Byron House**
**Cambridge Business Park**
**Cowley Road**
**Cambridge CB4 0WZ (GB)**

Remarks:
Amended claims in accordance with Rule 137(2) EPC.

(54) **BIOSENSING APPARATUS**

(57) A biosensing apparatus is described. The biosensing apparatus comprises a Hall effect sensor (41; 42; 51; 58; 61; 68) comprising a Hall element (42; 42') and a set of four contacts ($27_1$, $27_2$, $27_3$, $27_4$) to the Hall element for performing a Hall effect measurement. The Hall effect sensor comprises a substrate (81) and a layer structure (83) disposed on the substrate. The layer structure has a principal surface (84) and provides the Hall element (42'). The Hall effect sensor has holes (85) penetrating into or through the layer structure from the principal surface, such that the Hall element contains through holes (46). The apparatus further comprises a binding layer (89) for binding capture molecules (90) thereto, coating selective regions of the Hall effect sensor, outside the holes on the principal surface and/or inside the holes.

Fig. 25

**EP 4 312 039 A1**

## Description

### Field

The present invention relates to a biosensing apparatus in particular, but not exclusive, for use in magnetic biosensing.

### Background

A biosensor can be used to sense or detect the presence of a target analyte, such as protein, DNA or RNA, in a sample which may take the form of, for example, blood, serum, or saliva.

In magnetic biosensing, the target analyte binds to a magnetic particle (or "label"), and an external magnetic field is applied to magnetically polarize the label. The presence of the label and, thus, the analyte is identified by detecting the stray field from the polarized magnetic label. Reference is made to Talha Jamshaid et al.: "Magnetic particles: From preparation to lab-on-chip, biosensors, microsystems and microfluidics applications", Trends in Analytical Chemistry, volume 79, pages 344 to 362 (2016).

Magnetic biosensing generally has the advantage of being largely insensitive to the sample matrix since most biological samples tend to have negligible magnetic content. Thus, components of the sample usually do not interfere with magnetic transduction. As a result, sample purification and processing (to remove interfering components) are usually kept to a minimum and may not even be necessary. Another advantage, is that an array of magnetic sensors or detectors can be easily formed, thereby enabling multiplexing.

Currently, many forms of magnetic biosensing devices are based on giant magnetoresistance (GMR), and examples of GMR-based devices can be found in Richard S Gaster et al.: "Matrix-insensitive protein assays push the limits of biosensors in medicine", Nature Medicine, volume 15, pages 1327 to 1332 (2009) and Joohong Choi et al.: "Portable, one-step, and rapid GMR biosensor platform with smartphone interface" Biosensors and Bioelectronics, volume 85, pages 1-7 (2016).

Although GMR sensing is inherently very sensitive, it suffers a number of drawbacks. First, GMR sensors tend to saturate at low magnetic fields thereby limiting the strength of the applied field that can be used to magnetically polarize the magnetic label. As such, the magnetic material used for the label needs to be selected such that the label can be sufficiently polarized in a low field and so produce an adequate stray field capable of being detected. Secondly, GMR has a limited range of driving conditions with a linear response. Thirdly, a GMR sensor contains magnetic material and there may be a sensor-generated magnetic noise contribution to the overall signal.

Magnetic sensing based on the Hall effect has also been proposed and reference is made to Hua Fan et al.: "Detection techniques of biological and chemical Hall sensors", RSC Advances, volume 11, page 7257 (2021).

Hall effect sensors do not saturate in high magnetic fields, exhibit a linear response over a wide range of magnetic fields and do not themselves contribute to magnetic noise. Furthermore, processes used to fabricate Hall effect sensors are well-established, and are compatible with CMOS processes. This allows Hall effect sensors and control circuitry to be integrated on the same chip.

Hall effect sensors, however, also suffer drawbacks. First, if the sensing region of the Hall effect sensor is large compared to a magnetic label generating a dipole-like stray field, then opposing components of the stray field cancel out (in an integral sense) and so the net Hall signal will tend to zero. As the sensing region becomes larger relative to the size of the magnetic label, the cancellation effect becomes more pronounced. Secondly, the measured signal is sensitive to the position of the label on the sensing region.

These two issues place constraints on the size of the sensing region, namely that the sensing region should be similar in size to the magnetic label. If only one label can be detected per sensing region, then this can make the formation of large arrays of detectors and corresponding addressing circuitry more difficult. Being limited to small arrays can significantly reduce the dynamic range of detection, as well as the limit of detection for a given waiting time.

Other Hall effect sensors are described in US2015/280109 A1.

Reference is also made to US 2020/336136 A1.

### Summary

According to a first aspect of the present invention there is provided a biosensing apparatus comprising a Hall effect sensor comprising a Hall element and four contacts to the Hall element for performing a Hall effect measurement, and circuitry coupled to the four contacts for performing a Hall effect measurement.

The Hall effect sensor comprises a substrate and a layer structure supported on the substrate. The layer structure has a principal surface and provides the Hall element. The Hall effect sensor has holes penetrating into or through the layer structure from the principal surface, such that the Hall element contains through holes. The apparatus further comprises a binding layer for binding capture molecules thereto, coating selective regions of the Hall effect sensor, outside the holes on the principal surface and/or inside the holes.

The binding layer may coat one of either the hole surfaces inside the holes or the principal surface outside the holes. For example, the binding layer may coat the principal surface outside the holes, but not hole surfaces inside the holes, or the binding layer may coat the hole surfaces inside the holes, but not the principal surface outside the holes. Alternatively, the binding layer may coat selected regions of the principal surface outside the holes, but not the rest of the principal surface outside the holes or hole surfaces inside the holes.

The binding layer may comprise or consist of gold. The binding layer may comprise or consist of a metal selected from the group consisting of ruthenium, rhodium, palladium, osmium, iridium, platinum or silver.

The Hall effect sensor may further comprise a dielectric layer interposed between the binding layer and the layer structure.

The Hall effect sensor may further comprise capture molecules bound to the binding layer. The capture molecules may consist of DNA, antibodies or ligands.

The Hall element may comprise an electrically-conductive layer embedded in the layer structure.

The Hall element may include a sensing region and the through-holes may be in the sensing region. There may be between 100 and 10,000 through-holes in the sensing region, preferably between 1,000 and 5,000 through-holes.

The Hall element may include four arms, and each arm interposed between a sensing region and a respective one of the four contacts. The side arms can help to reduce edge effects and result in better homogeneity. The arms may contain through-holes.

The through-holes may include polygonal through-holes, square through-holes, rectangular through-holes, elliptical or circular through-holes.

The through-holes may be arranged in an array, such as a square array. This can help maintain linearity of response (i.e., signal as a function of number of magnetic particles detected). The Hall element may be covered by a least one dielectric layer. The through-holes may be partially or fully filled with dielectric material.

The apparatus may further comprise a magnetic field source arranged to apply a magnetic field to the Hall effect sensor.

The Hall element may comprise an electrically-conductive layer embedded in a layer structure.

According to a second aspect of the present invention there is provided a method of operating a biosensing apparatus of the first aspect, the method comprising providing magnetic labels to the Hall effect sensor, and performing a Hall effect measurement using the circuitry.

## Brief Description of the Drawings

Certain embodiments of the present invention will now be described, by way of example, with reference to the accompanying drawings, in which:

Figures 1a and 1b are schematic views of a first analyte-detecting arrangement based on magnetic biosensing before and after binding, respectively;
Figures 1c and 1d are schematic views of a second analyte-detecting arrangement based on magnetic biosensing before and after binding, respectively;
Figure 2 is a perspective view of a reference Hall effect sensor, and measurement circuitry, together with a magnetic label located above a Hall element of the sensor;
Figure 3 is a schematic side view of the magnetic label located above the Hall element of the reference Hall effect sensor shown in Figure 2;
Figure 4 is a plan view of the reference Hall effect sensor shown in Figure 2;
Figure 5 is a plan view of a first Hall effect sensor having a Hall element which has square through-holes;
Figure 6 is a plan view of a second Hall effect sensor having a Hall element which has square through-holes and slots;
Figure 7 is a partial plan view of the second Hall effect sensor shown in Figure 6;
Figure 8 is a plan view of a third Hall effect sensor having a Hall element which has circular through-holes;
Figure 9 is a plan view of a fourth Hall effect sensor having a Hall element which has circular through-holes;
Figure 10 is a partial plan view of the fourth Hall effect sensor shown in Figure 9;
Figure 11 is a perspective view of a fifth Hall effect sensor having a Hall element which has square through-holes and slots;
Figure 12 is a partial perspective view of magnetic labels lying above the Hall element between the through-square holes in the Hall element of the fifth Hall effect sensor shown in Figure 11;
Figure 13 is a partial plan view of magnetic labels located above a Hall element between the square through-holes in the Hall element of the fifth Hall effect sensor shown in Figure 11;
Figure 14 is a schematic side view of a magnetic label lying above the Hall element between through-square holes of the Hall element of the fifth Hall effect sensor shown in Figure 11;

Figure 15 is a perspective view of a sixth Hall effect sensor having a Hall element which has circular through-holes;

Figure 16 is a partial perspective view of magnetic labels lying above a Hall element between circular through-holes in the Hall element of the sixth Hall effect sensor shown in Figure 15;

Figure 17 is a partial plan view of magnetic labels lying above a Hall element between circular through-holes in the Hall element of the sixth Hall effect sensor shown in Figure 15;

Figure 18 is a schematic side view of a magnetic label lying above the Hall element between circular through-holes of the Hall element of the sixth Hall effect sensor shown in Figure 15;

Figure 19 is a partial perspective view of magnetic labels lying above a Hall element over circular through-holes in the Hall element of the sixth Hall effect sensor shown in Figure 15;

Figure 20 is a partial plan view of magnetic labels lying above a Hall element over circular through-holes in the Hall element of the sixth Hall effect sensor shown in Figure 15;

Figure 21 is a schematic side view of a magnetic label lying above a Hall element over a circular through-hole in the Hall element of the sixth Hall effect sensor over in Figure 15;

Figure 22 is a partial perspective view of magnetic labels sitting in circular through-holes in the Hall element of the sixth Hall effect sensor shown in Figure 15;

Figure 23 is a partial plan view of magnetic labels sitting in circular through-holes in the Hall element of the sixth Hall effect sensor shown in Figure 15;

Figure 24 is a schematic side view of a magnetic label sitting in a circular through-hole in the Hall element of the sixth Hall effect sensor shown in Figure 15;

Figure 25 is a perspective view of the fifth Hall effect sensor shown in Figure 15, measurement circuitry, coils, coil drivers and a magnetic label;

Figure 26a is a plot of simulated gain as a function of sensing region width for structures of the second Hall effect sensor and a first label position where the label lies above a Hall element between square through-holes, and for the fourth Hall effect sensor for a first label position where the label lies above a Hall element between circular through-holes and for a second label position where the label lies above a Hall element over a circular through-hole, wherein each respective label is an isolated label which is at the centre of the respective device;

Figure 26b is a plot of simulated gain as a function of sensing region width for structures of the fourth Hall effect sensor for a second label position in which the label lies above a Hall element over a circular through-hole and a third label position where the label sits in a circular through-hole in the Hall element, wherein each respective label is an isolated label which is at the centre of the respective device;

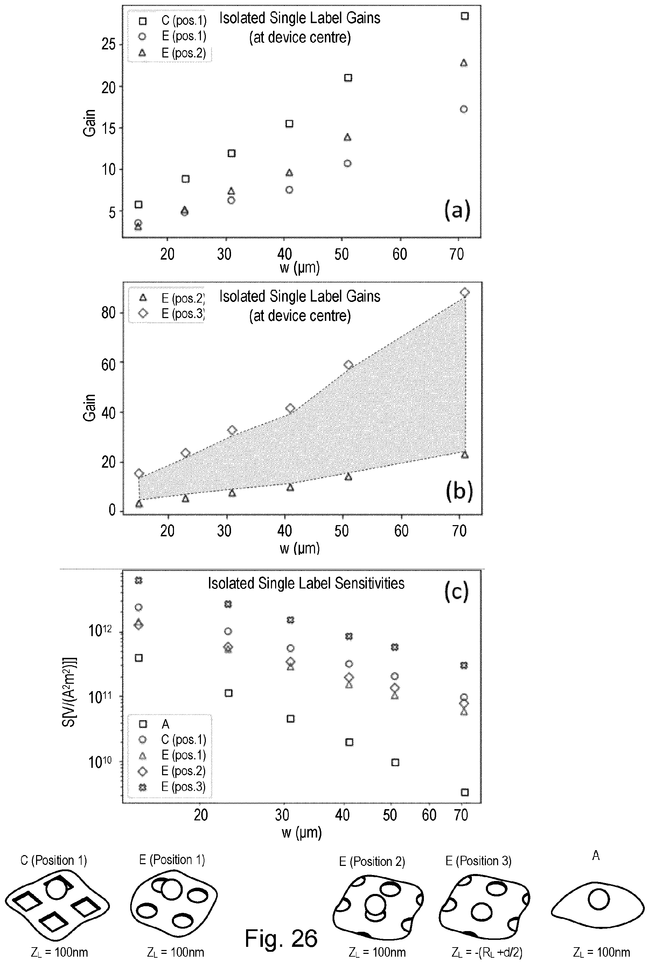

Figure 26c is a plot of simulated sensitivity as a function of sensing region width for structures of the reference Hall effect sensor, for the second Hall effect sensor and a first label position in which the label lies above a Hall element between square through-holes, and for the fourth Hall effect sensor for a first label position in which the label lies above a Hall element between circular through-holes, for a second label position in which the label lies above a Hall element over a circular through hole, and for a third label position in which the label sits in a circular through-hole in the Hall element, wherein each respective label is an isolated label which is at the centre of the respective device;

Figure 27a is a plot of simulated Hall voltage as a function of number of labels for structures of the reference Hall effect sensor, for the second Hall effect sensor and a first label position in which the label lies above a Hall element between square through-holes, and for the fourth Hall effect sensor for a first label position in which the label lies above a Hall element between circular through-holes, and for a second label position in which the label lies above a Hall element over a circular through-hole;

Figure 27b is a plot of simulated Hall voltage as a function of number of labels for structures of the reference Hall effect sensor and for the fourth Hall effect sensor for a second label position in which the label lies above a Hall element over a circular through-hole, and for a third label position in which the label sits in a circular through-hole in a Hall element;

Figure 27c is a plot of coefficient of variation for structures of the reference Hall effect sensor, for the second Hall effect sensor and a first label position in which the label lies above a Hall element between square through-holes, and for the fourth Hall effect sensor for a first label position in which the label lies above a Hall element between circular through-holes, for a second label position in which the label lies above a Hall element over a circular through-hole, and for a third label position in which the label sits in a circular through-hole in a Hall element;

Figure 28 is a process flow diagram of a method of fabricating a Hall effect sensor;

Figure 29 is a cross sectional view of an unpatterned layer structure;

Figure 30 is a cross sectional view of a layer structure which includes an electrically-conductive layer embedded in one or more layers;

Figure 31 is a cross sectional view of a patterned layer structure;

Figure 32 is a cross sectional view of a coated, patterned layer structure;

Figure 33 is a cross sectional view of a first patterned layer structure having binding material between holes and which is ready to be functionalized;
Figure 34 is a cross sectional view of a second patterned layer structure having binding material inside holes and which is ready to be functionalized;
Figure 35 is a cross sectional view of a first functionalized, patterned layer structure having capture molecules and binding material between holes; and
Figure 36 is a cross sectional view of a second functionalised, patterned layer structure having capture molecules and binding material inside holes.

**Detailed Description of Certain Embodiments**

Introduction

Herein, devices are described in which the Hall element is perforated with an array of holes. Even though the extent of the sensing region is much larger than a magnetic label (i.e., the area is much larger than the dimensions of the label), the devices can still sense individual magnetic labels. Simulations show that, for a hole-patterned Hall element, the effect of diminishing Hall voltage with increasing Hall element size exhibited by a continuous Hall element is attenuated. Thus, for a given driving current, a larger signal can be achieved for a label positioned on or over a hole-patterned Hall element compared to an unpatterned Hall element. This potentially makes it possible to count large numbers of labels bound to just one Hall element even with single-label resolution. In addition to enhancement of single-label signal contributions, this arrangement may improve signal homogeneity, that is, reduce the dependence of the detected Hall-voltage with respect to label position over or on the Hall element.

The array of holes through the Hall element divides the Hall element into smaller Hall elements (or "sub-Hall elements"). Labels can sit between the holes with surrounding voids, sit over the holes at a given height or sit (partially or fully) in the holes. The parts of the stray fields that permeate voids do not contribute to the Hall effect generated signal. This reduces integral stray field cancellation, resulting in an increase in signal and, therefore, a higher signal-to-noise ratio. In addition, simulations show that variability in single label signal contributions is significantly reduced, meaning that the dependence of the signal on the position of the label (i.e., which site is being occupied) is also reduced. This translates to an enhanced linearity in the relationship between signal versus number of labels occupying the Hall element.

The devices described herein can be used to detect the presence of and enumerate magnetic particles (herein also referred to as "magnetic labels" or simply "labels"). These labels can be ferromagnetic, superparamagnetic, paramagnetic or synthetic antiferromagnetic (i.e., engineered particles containing at least two ferromagnetic layers that are antiferromagnetically coupled).

Herein, a use case is described involving detection of analytes such as biological molecules, e.g., antigens, proteins in general and nucleic acids such as DNA, by detecting the labels they are bound thereto. However, devices can be used in other use cases.

To aid clarity, sample delivery structures are not described in detail. Suitable sample delivery structures may, however, take the form of positioned static reaction wells, for example, as described in Choi *ibid.* or macro- or microfluidic delivery systems, for example, as described in US 2012/122732 A1, both of which are incorporated herein by reference.

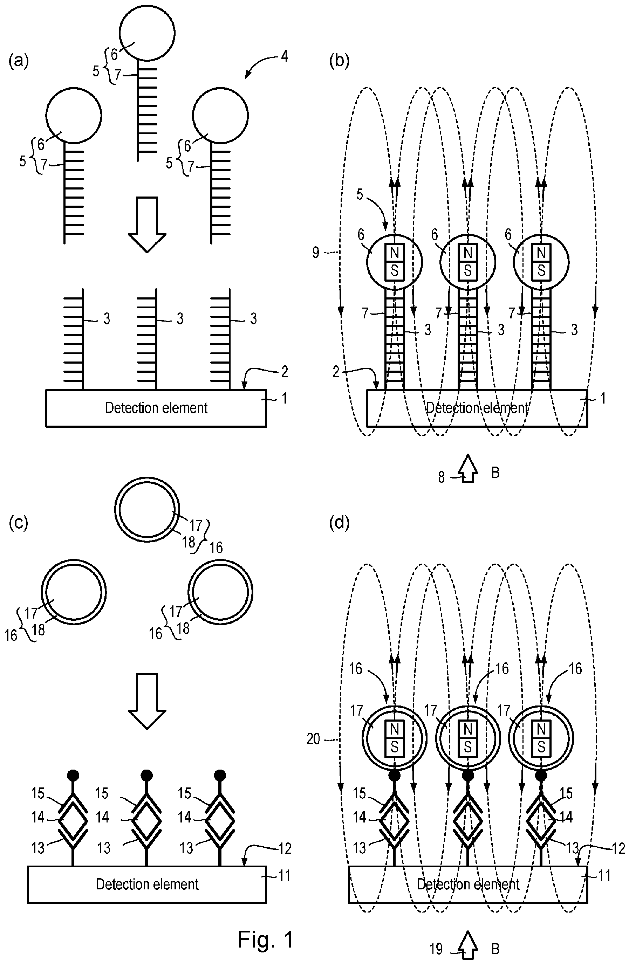

Referring to Figures 1a, 1b, 1c and id, first and second examples of analyte detection using magnetic biosensing are shown. The first example involves detection of DNA. The second example involves immunoassay, for example, for antigen detection.

Referring in particular to Figure 1a, an element 1 for detecting a magnetic field ("a magnetic field detection element" or simply "detection element") has a surface 2 which is functionalized by immobilizing single-stranded DNA 3 on the surface 2. The detection element 1 is exposed to a sample 4 (typically in liquid form) which contains functionalized labels 5, namely labels 6 attached to complementary DNA strands 7. The labels 6 are typically superparamagnetic (whereby they do not exhibit a net magnetization in the absence of any applied magnetic field) to help avoid the labels agglomerating due to magnetic dipole-dipole interaction. The labels 6 have been incubated with the complementary DNA strand 7. The functionalised labels 5 can be brought towards the immobilized DNA strands 3 on the detection element surface 2 by diffusion in the solution or by fluid flow, with or without the assistance of an external magnetic field (not shown).

Referring in particular to Figure 1b, upon reaching the functionalized sites on the detection element surface 2, the labels 5 chemically bind to the immobilized strands 3.

An external magnetic field 8 is then applied which magnetically polarize the labels 6 and so induces net magnetization. The labels 6 produce a magnetic stray field 9 which can be detected by the detection element 1. By detecting the magnetic stray field 9 from the labels 6, the presence of the target DNA 7 can be inferred.

Referring in particular to Figure 1c, a magnetic field detection element 11 has a surface 12 which is functionalized with capture antibodies 13. The detection element 1 is exposed to a sample (not shown) which contains the target analyte 14. The analytes 14 diffuse and specifically bind to the capture antibodies 13. This is chemically selective, in other words, other analytes that are present in the sample do not bind to the capture antibodies 13. Bioanylated antibodies 15 that specifically bind to the exposed parts of the now immobilized target analyte 14 are added (in a process known as "linker incubation"). Streptavidin-functionalized labels 16 comprising magnetic labels 17 having a streptavidin coating 18 are added that specifically bind to the biotin groups on the bioanylated antibodies 15. The target analyte 14 is now sandwiched between two antibodies 13, 15.

Referring in particular to Figure id, the streptavidin-functionalized labels 16 approach the detector surface 12 via diffusion alone or in conjunction with assisting methods as described in the first example.

The magnetic labels 17 are activated by an external magnetic field 19. The labels 17 produce a magnetic stray field 20 which can be detected by the detection element 11. By detecting the magnetic stray field 20 from the labels 17, the presence of the labels 16 can be inferred.

The detection elements 1, 11 hereinbefore described can take the form of a Hall element provided by a thin electrically-conductive layer. A Hall-active layer is the part of the Hall effect sensor exhibiting the Hall effect giving rise to the measured voltage-signal.

The Hall effect sensors hereinafter described generally comprise a cruciform Hall element. The Hall element includes a central region which serves as a sensing region and a set of four arms arranged such that the sensing region is interposed between the arms. The central region is preferably a rectangular prism having four sides.

When an electric current is driven through the Hall element and an external magnetic field is applied to the Hall element which includes a component which is perpendicular to the plane in which the Hall element lies, charge carriers (which maybe electrons and/or holes) in the sensing region are deflected perpendicular to both the current and the magnetic field due to the Lorentz force. This results in accumulation of charges of one polarity (e.g., negative) on one side of the Hall element and charges of the opposite polarity (e.g., positive) on the opposite side of the Hall element. This generates an electric field in a direction perpendicular to the direction of the driving current, and a voltage difference $V_H$ can be measured. The voltage difference $V_H$ is proportional to the driving current I and magnetic field B:

$$V_H \propto R_H.I.B \tag{1}$$

where B is the magnetic field component along a direction normal to the plane of the Hall element. B is the total net magnetic field impinging on the Hall layer. $R_H$ is the Hall coefficient, and is material dependent.

Reference Hall effect sensor having unpatterned Hall element

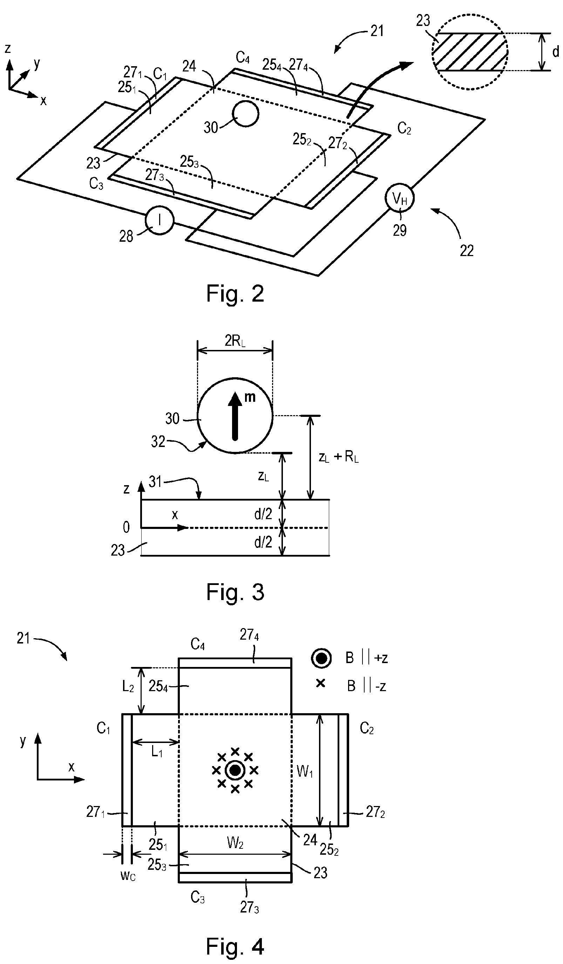

Referring to Figure 2, a reference Hall effect sensor 21 and DC measurement circuitry 22 is shown. The reference Hall effect sensor 21 is considered to be useful for understanding the invention, and serves as a reference for comparing Hall effect sensors described hereinafter that have Hall elements which include through-holes.

The reference Hall effect sensor 21 comprises a cross-shaped Hall element 23. The Hall element 23 includes a central region 24, which is generally square in plan view, and four arms 25, $25_1$, $25_2$, $25_3$, $25_4$. Each arm $25_1$, $25_2$, $25_3$, $25_4$ extends laterally from a respective side of the central region 24 and is provided with a respective electrical contact (or "terminal") $27_1$, $27_2$, $27_3$, $27_4$. Herein, the contacts $27_1$, $27_2$, $27_3$, $27_4$ are also labelled $C_1$, $C_2$, $C_3$, $C_4$.

First and second contacts $27_1$, $27_2$ ($C_1$, $C_2$) are connected to a voltage or current source 28 to produce a current I. In this case, a coordinate system is chosen in which the current flow along either the positive or negative x-direction. The third and fourth contacts $27_3$, $27_4$ ($C_3$, $C_4$) are used to measure the Hall voltage $V_H$ using a voltage meter 29. The Hall voltage $V_H$ is the electrical potential difference between the third and fourth contacts $27_3$, $27_4$ ($C_3$, $C_4$). Herein, the magnitude of the Hall voltage $V_H$ is used (its sign is not used).

The Hall element 23 comprises a thin, electrically-conductive layer and may be provided in a number of different ways.

The Hall element 23 may comprise a thin layer of electrically-conductive material, such as an epilayer or a stack of epilayers, disposed on top of a substrate (not shown). For example, the Hall element 23 may comprise a layer of an elemental semiconductor, such as silicon (Si) or germanium (Ge). The Hall element 23 may comprise a layer of a semiconductor alloy, such as indium antimonide (InSb), gallium arsenide (GaAs), indium phosphide (InP), indium arsenide (InAs) and other III-V (binary or tertiary) alloys, or a II-VI alloy. The Hall element 23 may comprise a layer of graphene. The Hall element 23 may take the form of a two-dimensional electron gas (2DEG) in a heterostructure comprising layers of, for example, InAlN, GaN, AlGaN and GaN. The Hall element 23 may take the form of a thin layer of doping ("doped layer") embedded in a layer, for example, formed by implantation. For instance, the doped layer may take the form of an n-type well in a p-type substrate, the n-type well providing the Hall element 23. Reference is made to Marco Crescentini et al.: "Optimum Design Rules for CMOS Hall Sensors", Sensors, volume 17, page 765 (2017).

The contacts $27_1$, $27_2$, $27_3$, $27_4$ preferably exhibit ohmic behaviour and have a high electrical conductivity.

Depending on the material system employed for the Hall element 23, the contacts $27_1$, $27_2$, $27_3$, $27_4$ may be formed from or include gold (Au), titanium (Ti), aluminium (Al), molybdenum (Mo) or combinations thereof. In the case of Hall element 23 provided by a doped layer, ohmic contacts may also be formed by heavy implantation doping, e.g., by n+ regions.

The Hall element 23 has a thickness d which lies in a range $0 < d \leqq 400$ nm and is preferably a thin as possible, e.g., $0 < d \leqq 100$ nm.

The Hall effect sensor 21 may include other layers, such as one or more electrically-insulating layers comprising dielectric material (not shown) disposed on top of the layer(s) providing the Hall element. The dielectric material may partially or fully fill the through-holes in a perforated Hall element. The dielectric material may be, for example, silicon dioxide ($SiO_2$), or silicon nitride ($Si_3N_4$).

The Hall effect sensor 21 may include additional layers on top of the electrically-insulating layer(s), such as a layer of gold (Au), for facilitating binding of biomolecules.

Referring also to Figure 3, a magnetic label 30 disposed over the Hall element 23 is shown.

In this case, the magnetic label 30 is superparamagnetic and has a radius $R_L$. An externally-applied magnetic field (not shown) magnetically polarizes the label 30 resulting in an induced magnetic moment m. For simplicity, the magnetic field (not shown) is orientated so as to orientate the moment m along the positive z direction. The magnetic field (not shown) may, however, be orientated in other directions. The distance from the upper surface 31 of the Hall element 23 to the closest point on the surface 32 of a label 30 is $z_L$.

Figure 4 shows the Hall effect sensor 21 in plan view. The sensor 21 has a continuous Hall element 23 (i.e., the Hall element 23 does not have through-holes). The continuous structure is herein described as "structure A" and a sensor having this structure is used as a comparative example.

The central region 24 (i.e., the sensing region) is rectangular having side widths $W_1$, $W_2$.

For magnetic biosensing, the central region 24 is preferably square in plan view, i.e., $W_1 = W_2 = W$, but need not necessarily be so. The widths $W_1$, $W_2$ of the central region 24 is preferably equal to or greater than 30 $\mu$m and less than or equal to 200 $\mu$m, i.e., 30 $\mu$m $\leq W_1$, $W_2 \leq 200$ $\mu$m, although the central region 24 may be bigger.

The first and second arms $25_1$, $25_2$ each have a length L1 running in a direction between the central region 24 and its respective contact $27_1$, $27_2$ (which in this case is along the x-direction) and a width $W_1$ in a direction (which is in this case is along the y-direction) which runs in a direction which is perpendicular to the length. Similarly, the third and fourth arms $25_3$, $25_4$ each have a length $L_2$ running in a direction between the central region 24 and its respective contact $27_3$, $27_4$ (which in this case is along the y-direction) and a width $W_2$ in a direction (which is in this case is along the x-direction) which runs in a direction which is perpendicular to the length. The lengths $L_1$, $L_2$ of the arms $25_1$, $25_2$, $25_3$, $25_4$, in particular, the ratio of the lengths $L_1/ L_2$ can be varied to enhance the sensitivity of a Hall-element. In this case, the ratio $L_1/ L_2$ is one. The arms $25_1$, $25_2$, $25_3$, $25_4$ need not be rectangular, but can be, for example, trapezoidal or tapered, having the same width as the central region 24 (i.e., $W_1$) where it is connected to the central region 24 and becoming wider further away from central region 24 (i.e., $W_1$' where $W_1$' $> W_1$).

The measured Hall voltage $V_H$ for the Hall effect sensor 21 is typically proportional to the total magnetic field expressed or considered in terms of an area-averaged magnetic field.

Referring in particular to Figure 4, the magnetic stray field B generated by the magnetic moment **m** from a label on or above the Hall sensor is dipolar in nature, resulting in magnetic flux along both positive and negative z-directions impinging upon the Hall element 23.

Since a positive magnetic field B component and a negative magnetic field B component yield signals of opposite signs in the Hall voltage $V_H$, the signals cancel out to a large degree in the integral sense if the radius of the magnetic label 30 is much smaller than the widths of the central region 24, i.e., $R_L < < W$. This may be viewed as the total surface-averaged field cancelling.

Figure 4 illustrates a scenario in which the magnetic field components from the label 30 (the label 30 is not shown in Figure 4 for clarity) result in a small net field due to cancellation in an integral sense over the area. Cancellation becomes stronger as the ratio $R_L /W$ becomes smaller.

One solution is to reduce W such that it is comparable in size to $2R_L$, thus retaining almost only one component of the stray field B. This, however, would mean that the Hall element is limited to measuring one label (i.e., one label per Hall-element). To detect *N* labels (where N is large, e.g., > 100), a similar number of Hall elements would be needed and would also need to be individually addressed. This would lead to complex, dense circuitry. Using a small number of Hall elements for the use cases described earlier would, however, limit dynamic range and limit of detection of the biosensor.

As will now be explained in more detail, another solution is to divide the Hall element using through-holes to produce a sensor comprising multiple, smaller, electrically-connected Hall elements and which still has only four contacts.

Hall effect sensors having patterned Hall elements

In the following, like parts are denoted with like reference numerals.

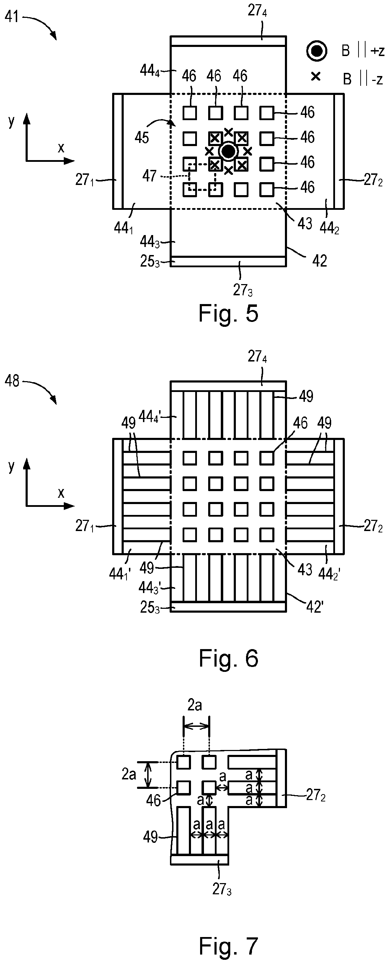

Referring to Figure 5, a first Hall effect sensor 41 is shown which is the same as the reference Hall effect sensor 21 (Figure 2) hereinbefore described except that the Hall element 42, in particular the central region 43, is perforated by an array 45 of square through-holes 46 (i.e., through-holes which are square in plan view). The arms $44_1$, $44_2$, $43_3$, $44_4$ are not perforated with through-holes. The geometry, widths $W_1$, $W_2$, lengths $L_1$, $L_2$, and Hall element thickness d are the same as the reference Hall effect sensor 21 (Figure 2).

The through-holes 46 contain a layer or coating of dielectric material. For example, the through-holes may partially or fully contain air or other gas, such as nitrogen. The through-holes 46 may partially or fully contain a liquid, such as a buffer solution. The through-holes 46 may be partially-filled with a solid, such as a layer of dielectric material and/or functional material.

This arrangement can be seen as forming an array of smaller, cross-shaped Hall elements 47 in the (larger) Hall element 42. The structure in which only the central region is perforated with an array of through-holes and the through-holes are square is herein described as "structure B".

The Hall element 42 comprises a thin, electrically-conductive layer and may be provided in a number of different ways, as hereinbefore described in relation to the reference Hall effect sensor 21 (Figure 2).

The through-holes 46 result in voids in the Hall element 42 and so any magnetic flux lines that pass through the voids do not contribute to the Hall voltage $V_H$.

When a label 30 (not shown in Figure 5) is disposed over a conductive part of the Hall element 42 (in other words, not disposed over a hole 46), a proportion of the opposite component of stray magnetic field B enters through the holes 46 and so do not contribute to stray field cancellation. This results in a high net stray magnetic field and, thus, a Hall voltage $V_H$ having a larger magnitude.

Referring to Figure 6, a second Hall effect sensor 48 is shown which is the same as the first Hall effect sensor 41 (Figure 5) hereinbefore described except that each arm $44_1'$, $44_2'$, $44_3'$, $44_4'$ of the Hall element 42' is perforated by rectangular through-holes 49 (herein also referred to as "elongate through-holes" or "slots"). The structure in which the central region is perforated with an array of square through-holes and the arms are perforated with rectangular through-holes is herein described as "structure C".

The rectangular through-holes 49 enhances confinement of the current lines from the driving current I to the sensing region, i.e., central region 43.

Referring also to Figure 7, the square through-holes 46 have a side length a. Preferably, $a = 2R_L$ and the hole center-center distance is 2a. The side length a may be between 500 nm to 4 $\mu$m, i.e., 500 nm $\leq a \leq 4$ $\mu$m, although the side length may be smaller or may be bigger. The elongate through-holes 49, if present, preferably have a width a and a slot-to-slot separation of a. Square holes having center-center distance is 2a may be used instead of slots.

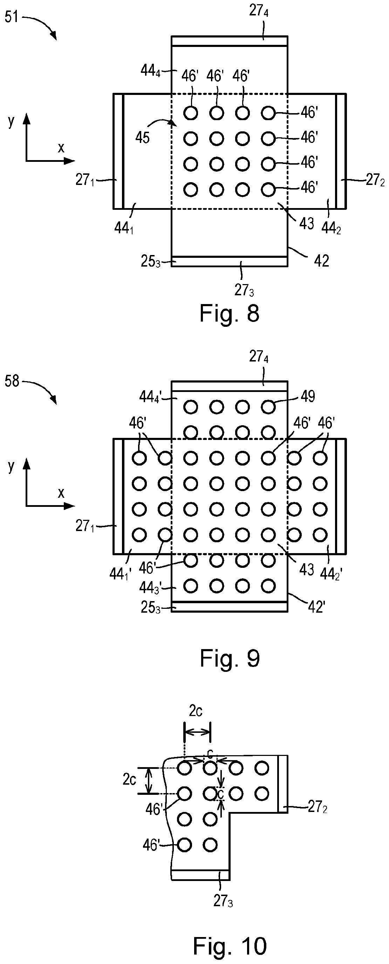

Referring to Figure 8, a third Hall effect sensor 51 is shown which is the same as the first Hall effect sensor 41 (Figure 4) hereinbefore described except that the through-holes 46' are circular in plan view. The geometry, widths $W_1$, $W_2$, lengths $L_1$, $L_2$, and thickness d are the same as the reference Hall effect sensor 21 (Figure 2). The structure in which only the central region is perforated with an array of through-holes and the through-holes are circular is herein described as "structure D".

Using circular holes 46' allows a label 30 (not shown in Figure 8) to be naturally positioned directly above or inside the holes 46' due to symmetry. This can have two benefits. First, seating a spherical label 30 in a circular-though hole 46' of the same diameter can help to maximise capture of one component of the magnetic stray field. Secondly, seating the label 30 in the middle of the through-hole 46' enables the distance between the label 30 and the Hall element 42, 42' to be further reduced thereby further boosting the signal since the magnetic field strength increases rapidly with decreasing separation.

Referring to Figure 9, a fourth Hall effect sensor 58 is shown which is the same as the third Hall effect sensor 51 (Figure 5) hereinbefore described except that each arm $44_1'$, $44_2'$, $43_3'$, $44_4'$ of the Hall element 42' is also perforated by circular through-holes 46. The through holes 46 are arranged in a square array. The structure in the whole Hall element is perforated with an array of circular through-holes is herein described as "structure E".

Referring also to Figure 10, the circular holes 46' have a diameter c. Preferably, $c = 2R_L$ and pitch (i.e., hole center to adjacent hole center) distance is 2c. The diameter c may be between 500 nm to 4 $\mu$m, i.e., 500 nm $\leq a \leq 4$ $\mu$m, although the diameter may be smaller or may be bigger. The through-holes 46' in the arms $44_1'$, $44_2'$, $43_3'$, $44_4'$, if present, preferably have a diameter c and pitch of 2c.

Generally, the higher the number of holes in the arms, the greater the measured signal. For example, comparing the simulated measured Hall voltage for structures D and E for one label, the measured signal for structure E is about 20% greater than the measured signal for structure D.

Label positions

Three label positions relative to through-holes in the Hall element will now be described.

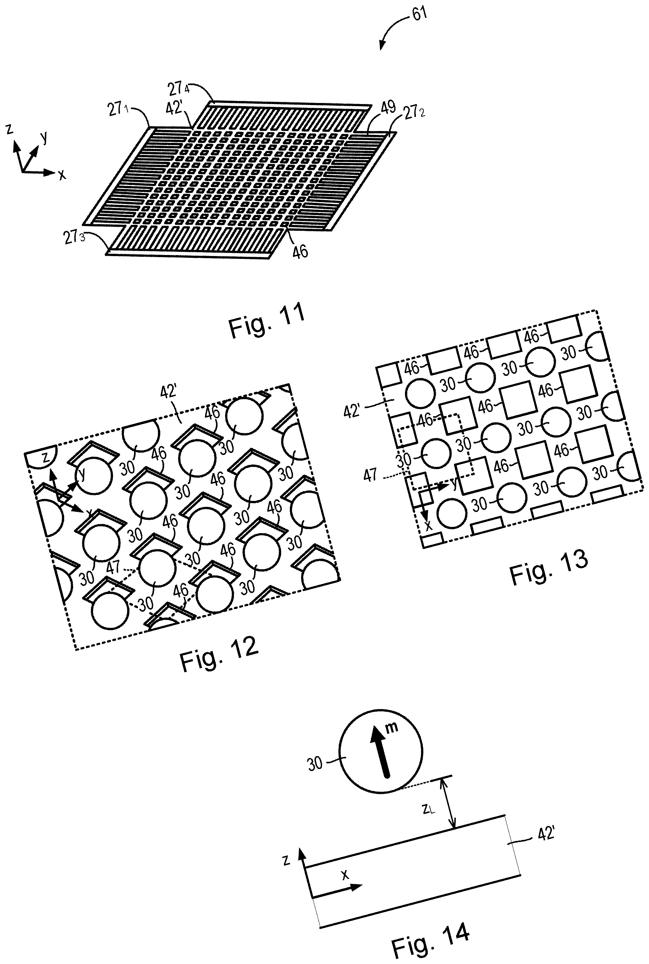

Referring to Figure 11, a fifth Hall effect sensor 61 is shown which is similar to the second Hall effect sensor 48 (Figure 6) hereinbefore described in that it shares the same structure, namely structure C, but has a larger number of holes and slots.

Figures 12 and 13 are perspective and plan views, respectively, of part of the fifth Hall effect sensor 61 showing magnetic labels 30 lying above the Hall element 42' at a height $z_L$ >0 between square through-holes 46 in the middle of a smaller Hall element 47. This label position is herein referred to as "Position 1" or "Pos. 1". Figure 14 is a side view of one of the magnetic labels 30 lying above the Hall element 42' in position 1.

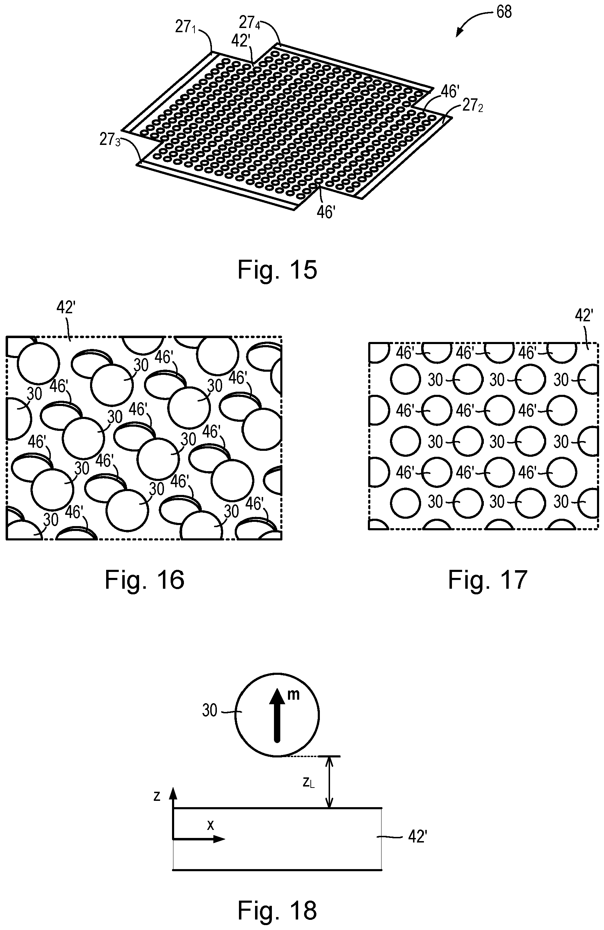

Referring to Figure 15, a sixth Hall effect sensor 68 is shown which is similar to the fourth Hall effect sensor 58 (Figure 9) hereinbefore described in that it shares the same structure, namely structure E, but that it has a larger number of holes.

Figures 16 and 17 are perspective and plan views, respectively, of part of the sixth Hall effect sensor 68 showing magnetic labels 30 lying above the Hall element 42' at a height $z_L$ >0 between circular through-holes 46'. This label position is herein referred to as "Position 1" or "Pos. 1". Figure 18 is a side view of one of the magnetic labels 30 lying above the Hall element 42' in position 1.

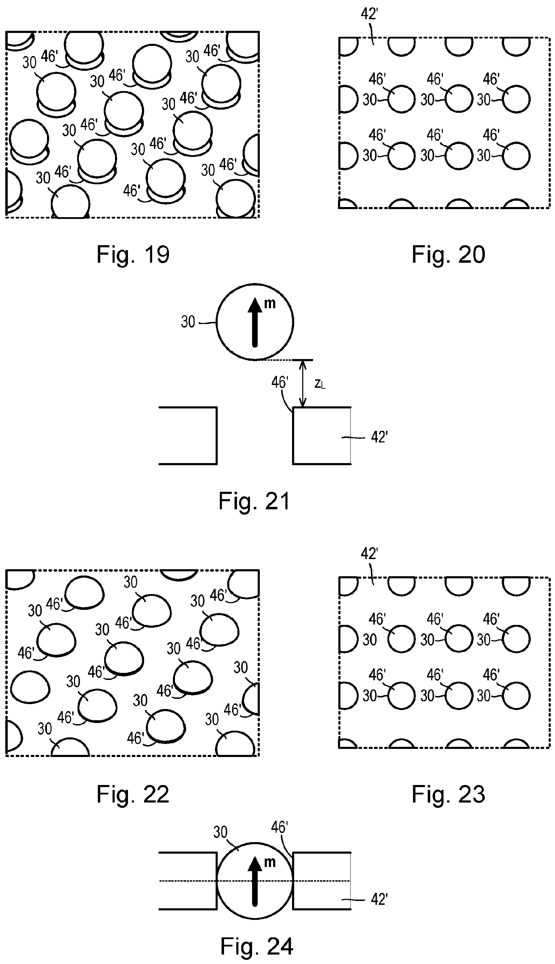

Figures 19 and 20 are perspective and plan views, respectively, of part of the sixth Hall effect sensor 68 showing magnetic labels 30 lying above the Hall element 42' at a height $z_L$ >0 over the circular through-holes 46'. This label position is herein referred to as "Position 2" or "Pos. 2". Figure 21 is a side view of one of the magnetic labels 30 lying above the Hall element 42' in position 2.

Figures 22 and 23 are perspective and plan views, respectively, of part of the sixth Hall effect sensor 68 showing magnetic labels 30 seated in the circular through-holes 46'. This label position is herein referred to as "Position 3" or "Pos. 3". Figure 24 is a side view of one of the magnetic labels 30 seated in a circular through-hole 46' in position 3. The magnetic label 30 sits so that its midline coincides with the midline of the layer 42'. In this position, the distance between the center of the dipole moment on the label 30 and the Hall element 42' is at a minimum, potentially yielding the highest possible signal.

In the following, combinations of structures (e.g., structure C, structure E *etc.)* and positions (e.g., position 1, position 2, *etc.)* are considered.

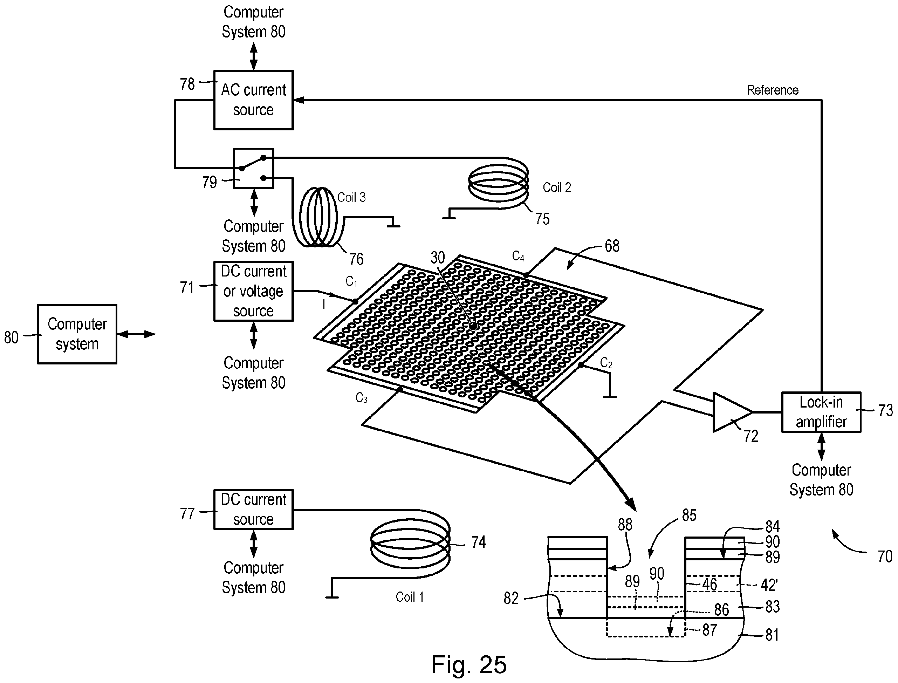

Referring to Figure 25, a Hall effect sensor, in this case, the sixth Hall effect sensor 68 is shown together with measurement circuitry 70, magnetic field generating coils 74, 75, 76, coil drivers 77, 78, a switch 79 for switching a signal between coils 75, 76, and a computer system 80 for controlling and recording measurements are shown.

The magnetic stray field B from a label 30 can be very weak, and so a simple DC measurement arrangement may be insufficient.

There are a number of different measurement arrangements which can be used to detect labels using the Hall effect such as, for example, a magnetic relaxation approach such as that described in Paul Peng Liu et al.: "Magnetic Relaxation Detector for Microbead Labels", IEEE Journal of Solid-State Circuits, volume 47, page 1056, (2012), or a phase-sensitive detection approach, which can be based on a single Hall-element, as described in Pierre-A. Besse, et al.: "Detection of a single magnetic microbead using a miniaturized silicon Hall sensor", Applied Physics Letters, volume 80, page 4199 (2002), or in a gradiometer configuration, as described in Goran Mihajlovic et al.: "Detection of single magnetic bead for biological applications using an InAs quantum-well micro-Hall sensor", Applied Physics Letters, volume 87, page 112502 (2005).

Referring to Figure 25, a DC current or a voltage source 71 is used to drive the Hall element with a current I. A first coil 74 is connected to a DC current source 77 and is used to provide an externally-applied magnetic field (not shown) to magnetically polarize labels and so induce a magnetic moment **m.** Second and/or third coils 75, 76 can be used to induce a small AC magnetic field that causes oscillation of the magnetic moment **m.** Oscillation of magnetic moment **m** produces an AC Hall-voltage signal which can then be used to isolate the detected signal from the background signal produced by the first coil 74. This is done via phase-sensitive lock-in detection using a low noise preamplifier 72 and lock-in amplifier 73. If the second coil 75 is used, then the lock-in detection is performed with respect to the first harmonic of the induced AC Hall-voltage. If the third coil 76 is used, the lock-in detection is performed at the second harmonic of the induced AC-Hall voltage. The computer system 80 is used to control the measurement circuitry 70, drivers 77, 78 and switch 79, and collect and process measurement data.

The Hall effect sensor 68 comprises a substrate 81 having an upper surface 82 and a layer structure 83 having an upper (or "principal") surface 84. The layer structure 83 provides the Hall element 42'. Holes 85 penetrate down from the principal surface 84 through the layer structure 83 to form the through holes 46 in the Hall element 42'. In this case, the Hall element 42' is shown forming part of the layer structure 83. In some cases, however, the Hall element 42' may form all of the layer structure 83 (and thus the holes 85 are also the through holes 45). For example, the layer structure 83 may consist of one layer, *e.g.,* of semiconductor material.

The holes 85 expose the upper surface 82 of the substrate or the bottom 86 of a blind hole 87 which penetrates into the substrate 81. The upper surface 82 of the substrate or the bottom 86 of a blind hole 87 may be coated, for example, by a layer (not shown) of dielectric material, such as silicon dioxide or silicon nitride. Side walls 88 of the holes 85 may be coated, for example, by the layer (not shown) of dielectric material that coats the upper surface 82 or the bottom 86 of a blind hole 87.

In some cases, the holes 85 extend not only through the Hall effect sensor 68, but also through the substrate 81 and, thus, the substrate 81 contains through holes (not shown) aligned with the through holes 46.

Parts of the surface of the Hall effect sensor are functionalized with capture molecules (or "functional material), such as single-strand DNA, antibodies or ligands. To promote adhesion of the capture molecules, those parts are covered with a thin coating of a noble metal, such as gold, or other suitable binding material. Generally, the extents of the binding material and capture molecules are coterminous. Dielectric material, such as silicon dioxide or silicon nitride, may be interposed between the binding material and the rest of the Hall effect sensor. In some cases, the extent of the dielectric material is also coterminous with the extent of the binding material. In others, however, the exposed parts of the Hall effect sensor may be covered or encapsulated by a dielectric coating so as to protect the sensor, for example, since it is being exposed to liquids.

Generally, the binding material and the overlying capture are disposed in one of two arrangements (or "layouts") depending on where it is intended to bind the magnetic labels 30. In a first arrangement, the binding material is disposed on the principal surface 84 of the Hall effect sensor 68 between the holes 85, but not inside the holes 85 and so the capture molecules are disposed over the principal surface 84 of the Hall effect sensor 68 between the holes 85, but not inside the holes 85. In a second arrangement, the binding material is disposed inside the holes 85, i.e., on hole surfaces, such as the bottoms 82, 86 of holes and/or hole sidewalls 88, but not on the principal surface 84 of the Hall effect sensor 68 between the holes and so the capture molecules are found inside the holes 85, but not outside the holes 85.

Referring still to Figure 25, a layer 89 of binding material and an overlying layer 90 of capture molecules (or "functional material") coat selective regions of the principal surface 82 and/or inside the holes 85 on the hole surfaces which may include exposed regions 82, 86 of the substrate 81 and/or side walls 88. In the case that the upper surface 82 of the substrate or the bottom 86 of a blind hole 87 is coated, for example with dielectric material, then the binding layer 89 is disposed on the exposed dielectric coating and the capture molecule layer 90 is formed on the binding layer 89. Additionally or alternatively, the binding layer 89 may be formed on the side walls 88 which may or may not be coated with the dielectric layer.

Simulation

Comparisons of Hall effect sensors having structure A to those having structure C and structure E will now be described.

Two properties of the Hall effect sensors are used, namely signal enhancement and signal scatter when many labels are sequentially loaded onto different positions on the Hall element. Signal enhancement is characterized in terms of signal sensitivity and signal gain for different sizes of the sensing region of the Hall element, i.e., values of width W. Signal scatter is characterized by a coefficient of variation CV.

Coefficient of variation CV is defined as the standard deviation divided by the mean and is determined as follows. Labels are loaded onto the Hall element on different sites within the sensing region in random order. The individual contribution to the Hall voltage $V_H$ as each label is added is recorded. When the sample of loaded labels is completed, the mean label signal is calculated and the standard deviation of the signal contributions of individual labels is computed. Coefficient of variation CV is then calculated as a ratio by dividing the standard deviation by the mean and expressed in percent.

The value of the CV indicates how strongly the Hall voltage $V_H$ depends on the position of the label within the sensing region. A small value of CV indicates good signal homogeneity and, thus, increased reliability for single label resolution of the signal. A high value of CV, on the other hand, indicates greater uncertainty in counting one single label at a time.

Three-dimensional finite element analysis is used to numerically simulate devices. COMSOL Multiphysics v. 6.0 software package using an AC/DC module is used.

The Hall effect due to the magnetic stray fields from labels is solved via current conservation using the Hall-conductivity tensor and the magnetic field from labels are solved via the magnetic scalar potential. The expressions used for the 3D Hall-conductivity tensor and general methodology for the simulation of Hall voltage $V_H$ can be found in J. Sun and J. Kosel: "Finite-Element Modelling and Analysis of Hall Effect and Extraordinary Magnetoresistance Effect", INTECH Open Access Publisher, pages 201-224 (2012).

Parameters used in the simulations are as follows:

- Hall-active layer thickness d = 100 nm;

- Label magnetic moment m = $1 \times 10^{-14}$ Am$^2$ and $R_L$ = 0.5 $\mu$m yielding a saturation magnetization $\approx$ 19.1 kA/m which is approximately half the saturation magnetization of a MyOneTM Dynabead and reference is made to Geir Fonnum et al.: "Characterization of Dynabeads by magnetization measurements and Mössbauer spectroscopy", J. Magn. Magn. Mater., 293, 41-47 (2005);
- W is varied between 15 $\mu$m $\leqq$ W $\leqq$ 71 $\mu$m;
- Lengths 2L$_1$+ W = 2L$_2$ + W are set to (45/31)$\times$W in all cases;
- Material parameters used for the Hall-active layer (i.e., the Hall element) are:

  ○ Carrier concentration $2 \times 10^{22}$ m$^{-3}$
  ○ Electrical mobility; 3.5 m$^2$V$^{-1}$s$^{-1}$.

The ability to produce high-mobility films for d = 100 nm at room temperature has been demonstrated for InSb layers and reference is made to Soo Seok Kang et al.: "High-Quality 100 nm Thick InSb Films Grown on GaAs(001) Substrates with an InxAl1-xSb Continuously Graded Buffer Layer", ACS Omega, volume 3, pages 14562-14566 (2018). The value of the mobility used in the simulations falls within the range reported in Kang *ibid.* The width of the electrical contacts, $w_C$ = 1.5 $\mu$m with a conductivity of $5 \times 10^7$ S/m.

Referring to Figures 26a to 26c, simulated values of gains in signal strength and sensitivity are shown.

To begin with, a single isolated label with its magnetic moment pointing along the +z-direction at the center of the device is considered. A driving current I = 150 $\mu$A is injected into the left-most horizontal arm into the first contact C1 and the second contact C2 is set to zero potential. The absolute value of the Hall voltage $V_H$ is determined via the potential difference between third and fourth contacts C3, C4.

The signal gain is here defined as the ratio of the determined $|V_H|$ for each structure (i.e., structure C and structure E) to the $|V_H|$ for structure A (in other words, the structure of the reference Hall effect sensor).

Sensitivity herein is defined to include not only the signal per unit driving current but also per unit magnetic moment. The sensitivity figure is valid for a given label-Hall-active layer separation $z_L$ as the signal is linear in both driving current I and magnetic moment m. The stray field generated by the label is proportional to its magnetic moment m. The signal is however not proportional to $z_L$ as the magnetic stray field falls away as the inverse cube of the distance of separation. Therefore, sensitives stated herein are to be understood in the context of the value of $z_L$ whereby they have been computed. The sensitivity S is defined as:

$$S = |V_H| \, I^{-1} \mathbf{m}^{-1} \tag{2}$$

and is expressed in units of VA$^{-2}$m$^{-2}$.

The signal gains and sensitivities have been determined as a function of the width W of the sensing region.

Referring to Figure 26a, signal gain factors are shown for (a) structure C with the label in position 1, (b) structure E with the label in position 1 and (c) structure E with the label in position 2, all with label lift height $z_L$ = 100 nm. Since the same label lift height $z_L$ is used, the results can be directly compared.

Structure C with the label in position 1 exhibits the most favourable gain. All three configurations, however, exhibit an improvement over the comparative example which uses structure A. The fact that these data points lie on a positive slope suggests that not only is a significant signal gain achieved, but also the rate of decay of the signal with respect to increasing W is lowered in comparison to comparative example. In other words, the rate at which stray field cancellation occurs as the Hall-active layer (i.e., Hall element) is made bigger in size is slowed down. Figure 26a thus illustrates a significant improvement by the approach to pattern the Hall element by introducing through-holes.

The possibility for further signal gains is possible if labels can sit in the holes.

Referring to Figure 26b, signal gain factors are shown for (a) structure E with the label in position 2 for label lift height $z_L$ = 100 nm and (b) structure E with the label sitting in a hole, in position 3, with its equator level with the center of the Hall-active layer or label lift height $z_L$ = - ($R_L$ + d/2).

The shaded region between the upper and lower curves shows the possible additional space of signal gains that may be obtained for -($R_L$ + d/2) $\leqq$ $z_L$ $\leqq$ 100 nm when labels are aligned with through-holes.

Referring to Figure 26c, plots of sensitivity S as a function of size W are shown.

In addition to providing significant signal gains, the plots show a reduction in the rate of sensitivity and therefore signal-decay as W increases. For a given label lift height $z_L$, the sensitivity enhancement S is independent of the material and driving parameters. Therefore, the enhancement S of sensitivity is a geometrical effect due to the presence of the holes. Thus, the benefits can be exhibited by any Hall active material system and any driving current.

Another figure of merit is the Coefficient of variation CV. A test calculation was performed, whereby a sample set of labels are randomly loaded, one-by-one, onto a Hall element within a sensing region and the Hall voltage $|V_H|$ is recorded as a function of the number of labels. The order of loading is random except for the fact that label sites by the holes closest to the boundary of the sensitive region were not included. This is because in a cross-shaped Hall element, the current has its highest degree of inhomogeneity close to Hall sensor arms.

For this test calculation, W = 31 $\mu$m and I = 150 $\mu$m.

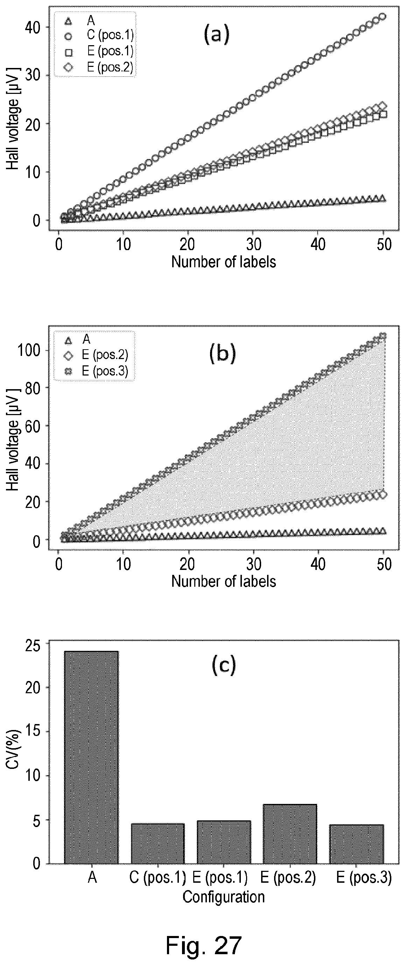

Figure 27a is a plot of simulated Hall voltage $|V_H|$ as a function of number of labels for (a) structure A, (b) structure C with the label in position 1, (c) structure E with the label in position 1 and (d) structure E with the label in position 2, all with label lift height $z_L$ = 100 nm.

Similar to the results for a single label, a high gain in signal can be achieved using Hall elements having through-holes (i.e., using structure C or structure D) as compared to structure A.

Figure 27b is a plot of simulated Hall voltage $|V_H|$ as a function of number of labels for (a) structure A, (b) structure E with the label in position 2, and (c) structure E with the label in position 3 . For structure A and structure E with label position 2, the label lift height $z_L$ is 100 nm.

The shaded region between the upper and lower curves shows the possible additional space of signal gains that may be obtained for $-(R_L + d/2) \leqq z_L \leqq$ 100 nm when labels are aligned with through-holes.

Figure 27c plots values of coefficient of variation CV for (a) structure A, (b) structure C with the label in position 1, (c) structure E with the label in position 1 and (d) structure E with the label in position 2, all with label lift height $z_L$ = 100 nm, and for (e) structure E with the label in position 3.

It is clear that structure A has a significantly higher CV than any of the structures. Thus, using through-holes can reduce CV from 24 % to 4.4%.

Fabrication

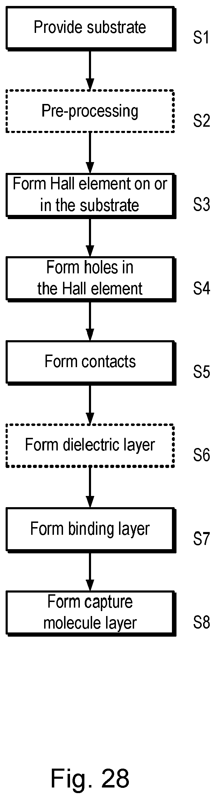

Referring to Figure 28, a method of fabricating the first, second, third, fourth, fifth or sixth Hall effect sensor 41 (Figure 5), 48 (Figure 6), 51 (Figure 8), 58 (Figure 9), 61 (Figure 11), 68 (Figure 15) is shown.

The Hall element of the first, second, third, fourth, fifth or sixth Hall effect sensor 41 (Figure 5), 48 (Figure 6), 51 (Figure 8), 58 (Figure 9), 61 (Figure 11), 68 (Figure 15) can be formed in a number of different ways, for instance, using a thin layer of electrically-conductive material, a 2DEG or a doped layer, using different material systems, for example, silicon, InSb, a heterostructure or implantation.

A suitable substrate 81 is provided (step Si). This may be a semiconductor substrate, such as a silicon wafer, or an electrically-insulating layer substrate, such as silicon dioxide or silicon dioxide on silicon.

Pre-processing steps may be carried out (step S2). This may include, for example, formation of mesa (not shown).

The Hall element is formed on or in the substrate 81 (step S3) and through-holes in the Hall element are formed (step S4). The Hall element can be formed by depositing layer(s), for example, using chemical vapour deposition (CVD) or molecular beam epitaxy (MBE), and subsequently patterning the layer(s), e.g., using optical lithography and etching. The Hall element and the through-holes may be formed at the same time. The Hall element may be formed by providing a mask and performing implantation through the mask.

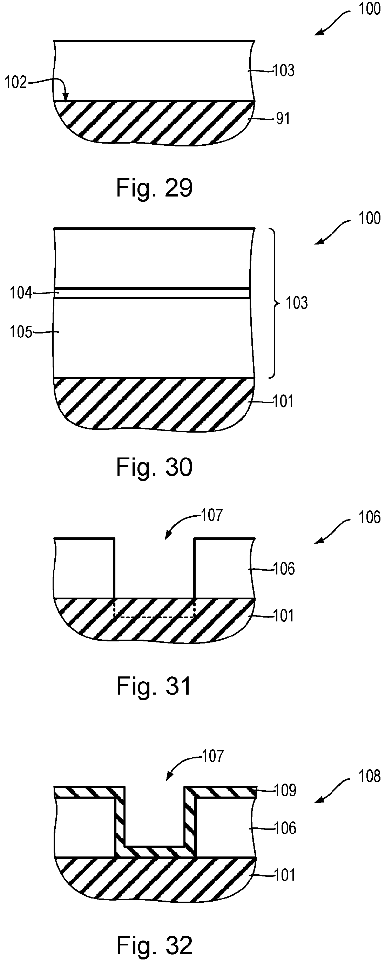

Referring to Figure 29, an unpatterned layer structure 100 is shown.

The unpatterned layer structure 100 comprises a substrate 101 having a surface 102, and a layer structure 103 comprising at least one layer disposed on the surface 102 of the substrate 101. The substrate 101 may be an electrically-insulating substrate or include a layer at or close to the surface 102 which is electrically-insulating.

Referring to Figure 30, the layer structure 103 may include an electrically-conductive layer 104, such as a thin layer of doped semiconductor material (such as n-type silicon), a layer of doping (such as delta-doping) or a 2DEG, embedded in one or more layers 105. For example, the one or more layers 105 may be a dielectric layer or layers, such as silicon dioxide. Thus, the layer structure 103 may take the form of silicon-on-oxide structure. The one or more layers 105 may, for instance, take the form of a layer of undoped semiconductor material, such as GaAs or silicon. Thus, the electrically-conductive layer 104 may take the form of a delta-doped layer embedded in silicon or GaAs. The layer structure 103 may take the form of a heterostructure, such as an GaAs/AlGaAs heterostructure. Thus, the electrically-conductive layer 104 may take the form of a 2DEG embedded in a heterostructure.

Referring to Figure 31, a patterned layer structure 106 is shown.

The patterned layer structure 106 may be formed by patterning the layer structure 103 (Figure 29) using optical lithography and etching, e.g., dry etching, to form the through holes 107.

If the Hall element is provided by an embedded electrically-conductive layer 104 (Figure 30), then the through holes 107 extend through the embedded electrically-conductive layer 104 (Figure 30). The through holes 107 may extend through the layer structure 103 and may penetrate into the substrate 101.

Referring again to Figure 28, the contacts to the Hall element are formed (step S5). The contacts may be formed by depositing layer(s), for example, using chemical vapour deposition (CVD) or physical vapour deposition (PVD) such as evaporation, and subsequently patterning the layer(s), e.g., using optical lithography and etching.

Further processing steps, such as defining and patterning dielectric layers may be carried out (step S6). A dielectric layer (not shown) may cover the Hall element and may fill or partially fill the through-holes.

Referring to Figure 32, a coated, patterned layer structure 108 is shown.

The patterned layer structure 106 (Figure 31) maybe coated with a layer 109 of dielectric material, such as silicon dioxide or silicon nitride. The layer 109 may have a thickness of between 10 nm to 1 $\mu$m.

As explained hereinbefore, in some embodiments, capture molecules may be disposed in one of two arrangements depending on where it is intended to bind the magnetic labels. Accordingly, in some embodiments, binding material maybe disposed in first and second arrangements, namely between holes and inside holes, respectively.

The binding material consists of a thin (e.g., <10 nm) of gold. Other noble metals, such as ruthenium, rhodium, palladium, osmium, iridium, platinum or silver, may be used, as well as other types of binding material which are not noble metals and which are better suited for binding capture molecules compared to the material at the surface of the sensor.

Referring again to Figure 28, binding material is formed on the sensor (step S7).

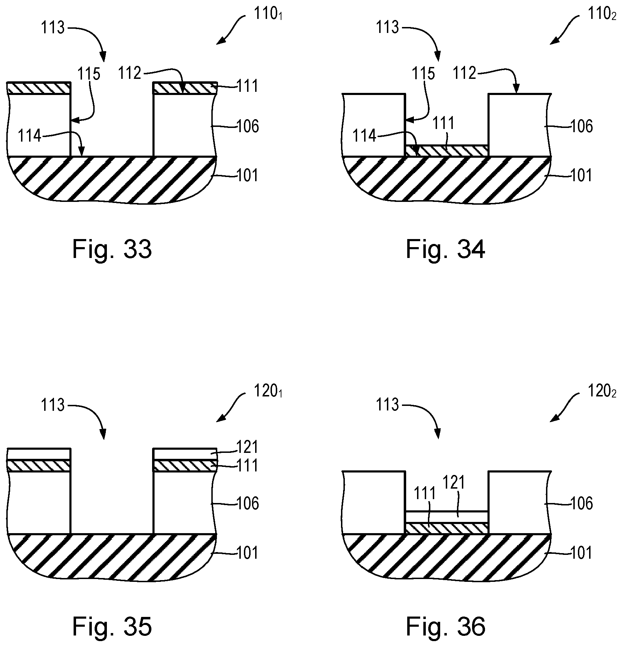

Referring to Figure 33, a first functionalizing-ready layer structure $110_1$ is shown.

The patterned layer structure 106 (Figure 31) or coated, patterned layer structure 108 (Figure 32) supports a layer 111 of binding material on a principal surface 112 between holes 113, but not inside the holes 113 (i.e., holes surfaces 114, 115 such as the bottom of the hole 114 or hole sidewalls 115).

The binding layer 111 may be formed by depositing the binding material, for example, using physical vapour deposition (PVD) such as evaporation or sputtering, and subsequently patterning the layer, e.g., using optical lithography and etching.

The binding layer 111 may be deposited and patterned before forming the holes and can be used as an etch mask for forming the holes. The binding layer 111 includes holes which expose the underlying layer structure 103. The through holes 107 are formed by etching.

Referring to Figure 34, a second functionalizing-ready layer structure 1102 is shown.

The patterned layer structure 106 (Figure 31) or coated, patterned layer structure 108 (Figure 32) supports layers 111 of binding material on at least one hole surfaces 114, 115, but not between holes 113.

The binding layers 111 may be formed by depositing the binding material, for example, using physical vapour deposition (PVD) such as evaporation or sputtering, and subsequently patterning the layer, e.g., using optical lithography and dry-etching.

At this point, the Hall effect sensor maybe operable as a sensor, but is not adapted for a particular use case. Thus, further steps are carried out to functionalize the sensor (step S8).

Referring to Figures 35 and 36, first and second functionalised, patterned layer structures $120_1$, $120_2$ are shown.

The first or second functionalizing-ready layer structure $110_{1,2}$ supports layer(s) of capture molecules 121, bound to the underlying binding layer 111.

The capture molecules may be deposited by several methods such as inkjet printing, for example as described in EP 3 333 605 A1, dip pen nanolithography, for example, as described in Pradeep Mandahar et al.: "The detection of specific biomolecular interactions with micro-Hall magnetic sensors", Nanotechnology, 20, 355501 (2009) or micro-contact-printing, for instance as described in Younan Xia et al.: "Non-Photolithographic Methods for Fabrication of Elastomeric Stamps for use in Microcontact Printing", Langmuir 1996, 12, 16, 4033-4038.

Use cases

Hall effect sensors having Hall elements which include through-holes can be employed in a number of different use cases.

*Portable cancer biomarker sensor*

The Hall effect sensor can be used as a portable, low-cost cancer biomarker sensor to screen for asymptomatic subjects and so help to detect the condition early. This is contrast to pathology lab analysers that are expensive and which tend to be centralised thereby limiting large-scale deployment.

*Antibody-based neurodegeneration sensor*

The Hall effect sensor can be used as an antibody-based sensor to detect minute amounts of neurodegeneration biomarkers for fast, sensitive, predictive blood tests in point of care settings.

*Magnetic label counter for detecting analytes for research/ R&D /testing*

The Hall effect sensor can be used as a label counter for research labs/ R&D /testing facilities to determine the amount of analyte that has been extracted using magnetic label separation by sensing the number of labels that have bound to the sensor due to the presence of the analyte.

*General magnetic label counter for hospitals*

This is focussed specifically on hospital setting for identifying hormones and proteins in blood/saliva/urine or other form of sample.

Modifications

It will be appreciated that various modifications may be made to the embodiments hereinbefore described. Such modifications may involve equivalent and other features which are already known in the design, manufacture and use of Hall effect sensors and component parts thereof and which may be used instead of or in addition to features already described herein. Features of one embodiment may be replaced or supplemented by features of another embodiment.

Although claims have been formulated in this application to particular combinations of features, it should be understood that the scope of the disclosure of the present invention also includes any novel features or any novel combination of features disclosed herein either explicitly or implicitly or any generalization thereof, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

**Claims**

1. A biosensing apparatus comprising:

   • a Hall effect sensor comprising a Hall element and four contacts to the Hall element for performing a Hall effect measurement; and
   • circuitry coupled to the four contacts for performing a Hall effect measurement; wherein the Hall effect sensor comprises a substrate and a layer structure disposed on the substrate, wherein the layer structure has a principal surface and provides the Hall element;

   wherein the Hall effect sensor has holes penetrating into or through the layer structure from the principal surface, such that the Hall element contains through holes; and
   wherein the apparatus further comprises a binding layer for binding capture molecules thereto, the binding layer coating selective regions of the Hall effect sensor, outside the holes on the principal surface and/or inside the holes.

2. The biosensing apparatus of claim 1, wherein the binding layer coats the principal surface outside the holes and not hole surfaces inside the holes.

3. The biosensing apparatus of claim 1, wherein the binding layer coats hole surfaces inside the holes and not the principal surface outside the holes.

4. The biosensing apparatus of any one of claims 1 to 3, wherein the binding layer comprises or consists of gold.

5. The biosensing apparatus of any one of claims 1 to 3, wherein the binding layer comprises or consists of a metal selected from the group consisting of ruthenium, rhodium, palladium, osmium, iridium, platinum or silver.

6. The biosensing apparatus of any one of claims 1 to 5, wherein the Hall effect sensor further comprises:

   • a dielectric layer interposed between the binding layer and the layer structure.

7. The biosensing apparatus of any one of claims 1 to 6, wherein the Hall effect sensor further comprises:

   • capture molecules bound to the binding layer.

8. The biosensing apparatus of any one of claims 1 to 7, wherein the capture molecules consist of antibodies or ligands.

9. The biosensing apparatus of any one of claims 1 to 8, wherein the Hall element comprises an electrically-conductive layer embedded in the layer structure.

10. The biosensing apparatus of any one of claims 1 to 9, wherein the Hall element includes a sensing region and the through-holes are in the sensing region.

11. The biosensing apparatus of any one of claims 1 to 10, wherein the Hall element includes four arms, each arm interposed between a sensing region and a respective one of the four contacts and wherein the through-holes are in least two of the four arms.

12. The biosensing apparatus of any one of claims 1 to 11, wherein the through-holes include polygonal through-holes, square through-holes, rectangular through-holes or circular through-holes.

13. The biosensing apparatus of any one of claims 1 to 12, wherein the through-holes are arranged in an array.

14. The biosensing apparatus of any one of claims 1 to 13, further comprising:

• a magnetic field source arranged to apply a magnetic field to the Hall effect sensor.

15. A method of operating the biosensing apparatus of any one of claims 1 to 14, the method comprising:

• providing magnetic labels to the Hall effect sensor; and
• performing a Hall effect measurement using the circuitry.


**Amended claims in accordance with Rule 137(2) EPC.**

1. A biosensing apparatus comprising:

· a Hall effect sensor (68) comprising a Hall element (42') and four contacts ($C_1$, $C_2$, $C_3$, $C_4$) to the Hall element for performing a Hall effect measurement; and
· circuitry (70) coupled to the four contacts for performing a Hall effect measurement; wherein the Hall effect sensor comprises a substrate (81) and a layer structure (82) disposed on the substrate, wherein the layer structure has a principal surface (84) and provides the Hall element;

wherein the Hall effect sensor has holes (85) penetrating into or through the layer structure from the principal surface, such that the Hall element contains through holes;
wherein the apparatus further comprises a binding layer (89) for binding capture molecules thereto, the binding layer coating selective regions of the Hall effect sensor, outside the holes on the principal surface and/or inside the holes; and
wherein the apparatus further comprises a magnetic field source (74) arranged to apply a magnetic field to the Hall effect sensor, the magnetic field having a component which is perpendicular to the principal surface.

2. The biosensing apparatus of claim 1, wherein the binding layer (89) coats the principal surface (84) outside the holes (85) and not hole surfaces (82, 86, 88) inside the holes.

3. The biosensing apparatus of claim 1, wherein the binding layer (89) coats hole surfaces (82, 86, 88) inside the holes (85) and not the principal surface (84) outside the holes.

4. The biosensing apparatus of any one of claims 1 to 3, wherein the binding layer (89) comprises or consists of gold.

5. The biosensing apparatus of any one of claims 1 to 3, wherein the binding layer (89) comprises or consists of a metal selected from the group consisting of ruthenium, rhodium, palladium, osmium, iridium, platinum or silver.

6. The biosensing apparatus of any one of claims 1 to 5, wherein the Hall effect sensor (68) further comprises:

· a dielectric layer interposed between the binding layer (89) and the layer structure (82).

7.  The biosensing apparatus of any one of claims 1 to 6, wherein the Hall effect sensor (68) further comprises:

    · capture molecules bound to the binding layer (89).

8.  The biosensing apparatus of any one of claims 1 to 7, wherein the capture molecules consist of antibodies or ligands.

9.  The biosensing apparatus of any one of claims 1 to 8, wherein the Hall element (42') comprises an electrically-conductive layer embedded in the layer structure (82).

10. The biosensing apparatus of any one of claims 1 to 9, wherein the Hall element (42') includes a sensing region and the through-holes are in the sensing region.

11. The biosensing apparatus of any one of claims 1 to 10, wherein the Hall element (42') includes four arms, each arm interposed between a sensing region and a respective one of the four contacts and wherein the through-holes are in least two of the four arms.

12. The biosensing apparatus of any one of claims 1 to 11, wherein the through-holes include polygonal through-holes, square through-holes, rectangular through-holes or circular through-holes.

13. The biosensing apparatus of any one of claims 1 to 12, wherein the through-holes are arranged in an array.

14. A method of operating the biosensing apparatus of any one of claims 1 to 13, the method comprising:

    · providing magnetic labels to the Hall effect sensor (68); and
    · performing a Hall effect measurement using the circuitry (70).

(a)

(b)

(c)

(d)

Detection element

Detection element

Detection element

Detection element

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

Fig. 17

Fig. 18

Fig. 19

Fig. 20

Fig. 21

Fig. 22

Fig. 23

Fig. 24

Fig. 25

Fig. 26

Fig. 27

Provide substrate — S1

Pre-processing — S2

Form Hall element on or in the substrate — S3

Form holes in the Hall element — S4

Form contacts — S5

Form dielectric layer — S6

Form binding layer — S7

Form capture molecule layer — S8

Fig. 28

100

102

103

91

Fig. 29

100

104

105

103

101

Fig. 30

107

106

106

101

Fig. 31

107

108

109

106

101

Fig. 32

Fig. 33

Fig. 34

Fig. 35

Fig. 36

Europäisches
Patentamt

European
Patent Office

Office européen
des brevets

# EUROPEAN SEARCH REPORT

Application Number

EP 22 18 6904

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 109 187 647 A (ZHONGSHAN KELITE OPTOELECTRONICS TECH CO LTD) 11 January 2019 (2019-01-11) * title, section "Example 1"; claim 8; figures 1-4 * | 1,3-15 | INV. G01R33/07 G01R33/12 G01N27/74 |
| X | JP 2007 187602 A (TOKYO INST TECH) 26 July 2007 (2007-07-26) * paragraph [0034]; figure 6 * | 1,2,4-15 | |
| A | EP 1 469 311 A1 (ASAHI CHEMICAL IND [JP]) 20 October 2004 (2004-10-20) * figures 1-5 * | 1-15 | |
| A | US 2011/018532 A1 (FLORESCU OCTAVIAN [US] ET AL) 27 January 2011 (2011-01-27) * figures 1-5 * | 1-15 | |

TECHNICAL FIELDS
SEARCHED (IPC)

G01R
G01N

The present search report has been drawn up for all claims

| Place of search | Date of completion of the search | Examiner |
|---|---|---|
| Munich | 10 January 2023 | Philipp, Peter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 18 6904

This annex lists the patent family members relating to the patent documents cited in the above-mentioned European search report.
The members are as contained in the European Patent Office EDP file on
The European Patent Office is in no way liable for these particulars which are merely given for the purpose of information.

10-01-2023

| Patent document cited in search report | | Publication date | Patent family member(s) | | Publication date |
|---|---|---|---|---|---|
| CN 109187647 | A | 11-01-2019 | NONE | | |
| JP 2007187602 | A | 26-07-2007 | NONE | | |
| EP 1469311 | A1 | 20-10-2004 | AU | 2003244342 A1 | 02-09-2003 |
| | | | CN | 1625686 A | 08-06-2005 |
| | | | DE | 60315415 T2 | 30-04-2008 |
| | | | EP | 1469311 A1 | 20-10-2004 |
| | | | JP | 4240303 B2 | 18-03-2009 |
| | | | JP | WO2003067258 A1 | 02-06-2005 |
| | | | TW | I306153 B | 11-02-2009 |
| | | | US | 2005106758 A1 | 19-05-2005 |
| | | | WO | 03067258 A1 | 14-08-2003 |
| US 2011018532 | A1 | 27-01-2011 | CA | 2711956 A1 | 23-07-2009 |
| | | | CN | 101971015 A | 09-02-2011 |
| | | | CN | 106324079 A | 11-01-2017 |
| | | | EP | 2235516 A2 | 06-10-2010 |
| | | | JP | 5466651 B2 | 09-04-2014 |
| | | | JP | 2011511936 A | 14-04-2011 |
| | | | KR | 20100115744 A | 28-10-2010 |
| | | | US | 2011018532 A1 | 27-01-2011 |
| | | | WO | 2009091926 A2 | 23-07-2009 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2015280109 A1
- US 2020336136 A1
- US 2012122732 A1
- EP 3333605 A1

### Non-patent literature cited in the description

- **TALHA JAMSHAID et al.** Magnetic particles: From preparation to lab-on-chip, biosensors, microsystems and microfluidics applications. *Trends in Analytical Chemistry,* 2016, vol. 79, 344-362
- **RICHARD S GASTER et al.** Matrix-insensitive protein assays push the limits of biosensors in medicine. *Nature Medicine,* 2009, vol. 15, 1327-1332
- **JOOHONG CHOI et al.** Portable, one-step, and rapid GMR biosensor platform with smartphone interface. *Biosensors and Bioelectronics,* 2016, vol. 85, 1-7
- **HUA FAN et al.** Detection techniques of biological and chemical Hall sensors. *RSC Advances,* 2021, vol. 11, 7257
- **MARCO CRESCENTINI et al.** Optimum Design Rules for CMOS Hall Sensors. *Sensors,* 2017, vol. 17, 765
- **PAUL PENG LIU et al.** Magnetic Relaxation Detector for Microbead Labels. *IEEE Journal of Solid-State Circuits,* 2012, vol. 47, 1056
- **PIERRE-A. BESSE et al.** Detection of a single magnetic microbead using a miniaturized silicon Hall sensor. *Applied Physics Letters,* 2002, vol. 80, 4199
- **GORAN MIHAJLOVIC et al.** Detection of single magnetic bead for biological applications using an InAs quantum-well micro-Hall sensor. *Applied Physics Letters,* 2005, vol. 87, 112502
- **J. SUN ; J. KOSEL.** Finite-Element Modelling and Analysis of Hall Effect and Extraordinary Magnetoresistance Effect. INTECH Open Access Publisher, 2012, 201-224
- **GEIR FONNUM et al.** Characterization of Dynabeads by magnetization measurements and Mössbauer spectroscopy. *J. Magn. Magn. Mater.,* 2005, vol. 293, 41-47
- **SOO SEOK KANG et al.** High-Quality 100 nm Thick InSb Films Grown on GaAs(001) Substrates with an InxAl1-xSb Continuously Graded Buffer Layer. *ACS Omega,* 2018, vol. 3, 14562-14566
- **PRADEEP MANDAHAR et al.** The detection of specific biomolecular interactions with micro-Hall magnetic sensors. *Nanotechnology,* 2009, vol. 20, 355501
- **YOUNAN XIA et al.** Non-Photolithographic Methods for Fabrication of Elastomeric Stamps for use in Microcontact Printing. *Langmuir,* 1996, vol. 12 (16), 4033-4038